(19) Europäisches Patentamt
European Patent Office
Office européen des brevets

(11) EP 0 719 447 B1

(12) EUROPEAN PATENT SPECIFICATION

(45) Date of publication and mention
of the grant of the patent:
**22.07.1998 Bulletin 1998/30**

(51) Int Cl.6: **H01J 37/32**

(86) International application number:
**PCT/GB94/02027**

(21) Application number: **94926344.6**

(22) Date of filing: **16.09.1994**

(87) International publication number:
**WO 95/08182 (23.03.1995 Gazette 1995/13)**

(54) **RF PLASMA REACTOR**

RF PLASMAREAKTOR

REACTEUR HF A PLASMA

(84) Designated Contracting States:
**GB**

(30) Priority: **17.09.1993 GB 9319254**

(43) Date of publication of application:
**03.07.1996 Bulletin 1996/27**

(73) Proprietor: **ISIS INNOVATION LIMITED**
**Oxford OX1 3UB (GB)**

(72) Inventors:
• **ANNARATONE, Beatrice, Maria**
**Oxford OX2 8DZ (GB)**
• **ALLEN, John, Edward**
**Oxford OX1 4JE (GB)**

(74) Representative: **Perkins, Sarah**
**Stevens, Hewlett & Perkins**
**1 Serjeants' Inn**
**Fleet Street**
**London EC4Y 1LL (GB)**

(56) References cited:
**US-A- 4 933 203**

• **PATENT ABSTRACTS OF JAPAN vol. 12, no. 33 (C-472) 30 January 1988 & JP,A,62 180 747 (ANELVA CORP.) 8 August 1987**
• **JOURNAL OF THE PHYSICAL SOCIETY OF JAPAN, vol.60, no.9, September 1991, TOKYO JP pages 3015 - 3024 S. NONAKA 'General characteristics of the maintenance electric fields in planar radio frequency discharges'**

## Description

The present invention relates to an improved plasma reactor and to a method of operating the same. In particular the present invention is directed to a parallel plate plasma reactor suitable for use in etching and deposition treatments of wafers.

RF plasma reactors are used mainly in connection with etching and deposition of the components, for example semiconductors, insulators and metals which make up very-large-scale integrated (VLSI) electronic circuits. During manufacture of such components the rate at which either the etching or the deposition is performed and the quality of the component, that is the absence of defects, are of particular importance.

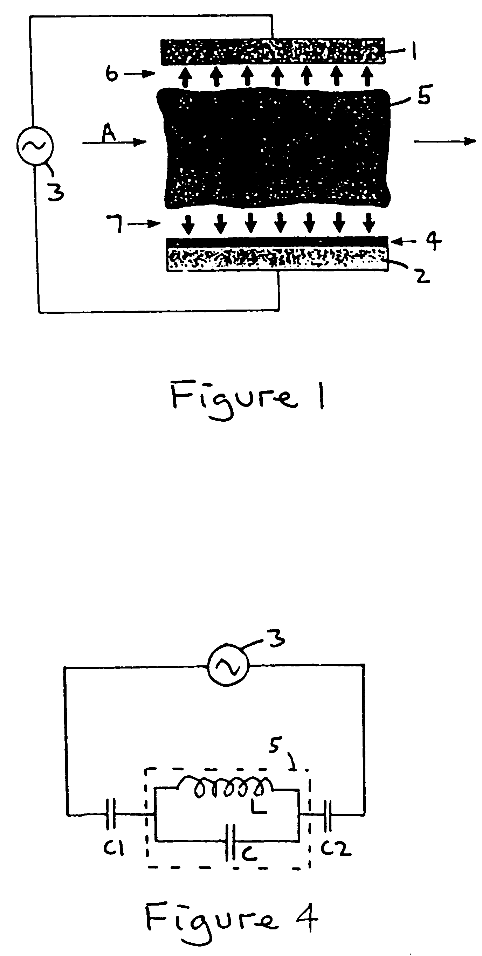

Figure 1 of the accompanying drawings shows a simplified diagram of a parallel plate plasma reactor of the type with which the present invention is concerned. The device comprises a pair of metal plate electrodes 1,2 to which an RF voltage, typically at a frequency of 13.56 MHz, is applied from an RF power source 3. Usually electrode 1 is the driven electrode and electrode 2 is grounded. A wafer 4 to be treated is placed on one of the two electrodes, as shown.

A gas at low pressure is passed between the plates, and is represented by the arrow A in Figure 1. For etching the gas employed may be for example argon, $CF_4$ or $SF_6$. For deposition a film-forming gas such as methane or thiolene may be used.

The RF voltage is sufficient to cause the gas to break down, forming a plasma 5 between the plates containing roughly equal numbers of ions and electrons. At the same time a space charge region, referred to as the sheath 6,7 appears between the plasma and each of the electrodes. The plasma in these circumstances is a glow discharge plasma having no overall electrical charge.

The use of such a conventional plasma reactor at pressures in the range 10 to 50 Pa is described in US-A-4933203 for the deposition of amorphous hydrogenated silicon. In US-A-4933203 selection of the frequency at which the plasma reactor is driven, between 25 and 150 MHz, is described. The selection is on the basis of the ratio of the frequency f with respect to the electrode separation d. That is f/d must be in the range 30 to 100 MHz/cm. Hence, this document establishes a direct relationship between the frequency f and the electrode separation d, whereby increasing one requires a commensurate increase in the other.

In JP-A-62-180747 a plasma reactor is described within which standing waves are established by means of a magnetic coil which applies an external magnetic field. The transverse magnetic field causes the ions within the plasma to describe helical trajectories which in turn enables a high-density plasma to be established.

With the present invention on the other hand, it has been found that for a fixed electrode separation appropriate selection of the frequency of the RF power source in combination with the pressure of the gas within the chamber can increase the amount of power which can be coupled to the system or can be used to couple the power more efficiently.

The present invention provides a method of generating a plasma in an evacuable chamber containing a first electrode spaced apart by a separation from a second electrode, the method comprising the steps of: supplying a gas at a pressure into the chamber; connecting a first RF power source between the first and second electrodes so as to generate a glow discharge plasma with a sheath; and controlling at least one of said pressure, said first RF power source and said electrode separation so as to generate one or more voltage gradients in said plasma between the first and second electrodes characterised by the voltage gradients being generated without an externally applied magnetic field.

Preferably a control device is provided to maintain the pressure of the gas within the chamber. The control device may also be used to vary the pressure of the gas within the chamber until plasma-sheath resonance in the glow discharge plasma is generated. Alternatively means for adjusting the electrode separation may be employed. In this way even if the exact conditions for generating the resonance are not known, resonance can be achieved through experimentation.

The voltage gradient generated in the region between the electrodes in the chamber can be in the form of a standing wave which has a frequency coinciding with or which is a harmonic of, the driving frequency of the RF power source.

In either method it is preferred that the pressure of the gas within the chamber is maintained at less than 10 Pa and ideally less than 2 Pa. A preferred frequency of the RF power source is 13.56 MHz.

Where the exact conditions for generating the plasma-sheath resonance or the standing wave are not known, the RF current between the electrodes may be monitored by means of a suitable meter. The current will tend towards a maximum when resonance or the standing wave is generated. Alternatively, the presence of a voltage gradient in the plasma between the electrodes in the chamber may be monitored directly by means of a high impedance probe.

In a further alternative, an additional RF power source may be connected to the electrodes so that the RF voltage applied to the electrodes is the superposition of two different frequencies. The additional RF power source may be a variable frequency power source and in particular one capable of supplying voltages at frequencies which are harmonics of the driving frequency. Furthermore, the additional power source preferably supplies an RF voltage having a peak-to-peak voltage less than the peak-to-peak voltage of the first RF power source.

With the present invention described above greater power can be coupled to the system or the power can be coupled more efficiently. This surprising effect in turn increases the flux of the system and enables higher etching rates to be achieved at low pressures. Moreover, with the present invention unexpectedly a plasma may be generated at gas pressures formerly considered below the lower limit of working pressures.

The present invention also provides a reactor comprising an evacuable chamber having a port through which gas is supplied; first and second electrodes located within the chamber and spaced apart from one another by a separation ; pumping means for maintaining sub-atmospheric pressure of gas supplied through the port; a first RF power source connected between said first and second electrodes for generating a glow discharge plasma and sheath within the chamber; and characterised by means for controlling at least one of said pressure, said RF power source and electrode separation in order to generate without an externally applied magnetic field a voltage gradient in the plasma between first and second electrodes.

Reference is made herein to the generation of a glow discharge plasma and to a plasma reactor. It will be appreciated that at the pressures and frequencies of interest plasmas generated by a glow discharge conventionally have a plasma sheath region across which a substantial portion of the applied RF voltage is distributed (i.e. high electric field) and a luminous plasma region having approximately equal numbers of ions and electrons across which only a relatively small portion of the voltage is distributed (i.e. low electric field) as shown by Figure 1, the plasma generated is in the form of an ionised gas having approximately equal numbers of positive ions and electrons. It is not intended that reference to a plasma implies the ionised gas either to be in equilibrium or linear. Indeed, it is believed that when resonance is generated the ionised gas is non-linear and not in equilibrium.

An embodiment of the present invention will now be described by way of example only with reference to the accompanying drawings, in which:

Figure 1 is a schematic diagram of a conventional plasma reactor;
Figure 2 is a schematic diagram of an improved plasma reactor in accordance with the present invention;
Figure 3 is a graph of the voltages measured between the electrodes of the improved plasma reactor at three different resonant frequencies; and
Figure 4 is a simplified schematization of the electrical properties of the system.

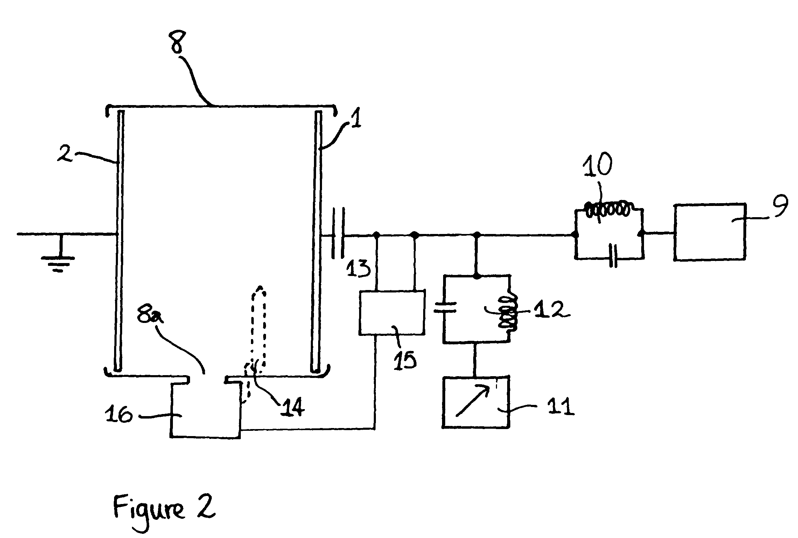

With reference to Figure 2 a plasma reactor is shown similar to that of Figure 1. The plasma reactor has a first electrode 1 which is driven by an RF power source and a second electrode 2 which is grounded. There are certain applications of the plasma reactor in which the second electrode would not be connected to ground and it is a matter of design and the particular application of the plasma reactor which will decide this.

The electrodes 1,2 are of the parallel plate type and are therefore mounted opposite and spaced apart from one another. The electrodes 1,2 are located within an vacuum chamber 8 which has a port 8a for the introduction of a gas under low pressure. The gas is supplied from a pump 16 which is arranged to control the pressure at which the gas is delivered and thereby the pressure of the gas within the chamber 8. The chamber 8 is arranged so that it may be opened to enable a wafer to be mounted on one or other of the electrodes.

Examples of suitable gases which could be used in wafer treatment with the plasma reactor are given earlier with reference to the conventional plasma reactor.

The electrodes 1,2 of the plasma reactor of Figure 2 are connected to a voltage supply which provides power at a driving frequency of 13.56 MHz superposed with a selected higher frequency. The peak-to-peak voltage of the higher frequency power supply may be less than the peak-to-peak voltage of the 13.56 MHz power supply. For example $V_{RF1}$ at 13.56 MHz may be 20v whereas $V_{RF2}$ at 54.24 MHz may be lv. The voltage supply shown in Figure 2 includes a 13.56 MHz amplifier 9 which is connected to a tuneable power choke 10 and a power generator 11 which is connected to a 13.56 MHz choke 12. The outputs of the power choke 10, and choke 12 are connected to the driven electrode 1 via a DC blocking capacitor 13.

The driving frequency is chosen to be 13.56 MHz since this is a frequency which is presently available for use to industry. It will of course be appreciated though that any suitable RF frequency voltage supply may be used with the plasma reactor of Figure 2. The higher frequency is carefully selected either by experiment or theoretically. The higher frequencies may be selected to be harmonics of the driving frequency. It is preferred that the higher frequency is less, but possibly near to the electron plasma resonance frequency which is the frequency at which the plasma resonates and the RF current between the electrodes tends to a minimum.

In order to generate a plasma the RF power supply is connected between the electrodes 1,2 and the pressure of the gas within the chamber 8 is carefully controlled by the pump 16 so as to be maintained at a predetermined level. At the predetermined pressure, which is preferably below 10 Pa, resonance is generated in the glow discharge plasma between the electrodes 1,2. This resonance greatly increases the coupling of the power to the system and is seen as an increase in the RF current between the electrodes. In circumstances at a particular driving frequency where the pressure needed to generate resonance is not known, the pump 16 may be used to vary the pressure of the gas within the chamber 8 until resonance is generated. In this way the desired pressure can be determined and thereafter the pump 16 is used to maintain the gas at the desired pressure.

Resonance may be detected in a number of different ways. For example, an RF current meter 15 may be used to monitor the current between the electrodes 1,2 externally of the chamber 8. The RF current increases when resonance has been established within the reactor. Alternatively, a high impedance probe 14 may be used to detect the presence of a voltage gradient within the plasma between the electrodes 1,2. The probe 14 may either be connected to a broad band choke or may utilise the electrical properties of the sheaths, which are formed either side of the plasma, in order to ensure the high impedance necessary to measure the voltages involved. It should be borne in mind that the resonance referred to herein is a resonance of the ionised particles in the chamber and is not a resonance of the probe.

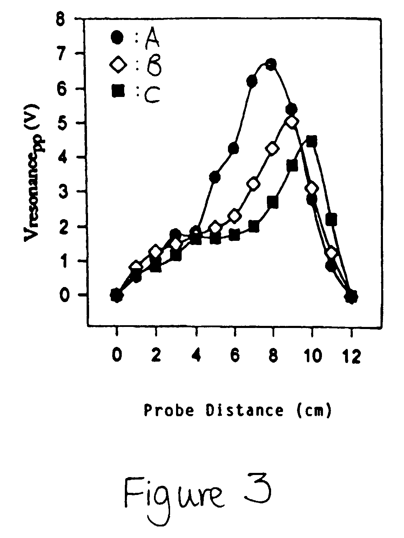

Figure 3 shows the results of the voltages measured by a high impedance probe 14 at different distances from the ground electrode 2 at three different pressures which correspond to three different resonant frequencies. The three different frequencies are in fact the fourth, fifth and sixth harmonics of the driving frequency, 13.56 MHz, of the power source. The first curve, A, is for a gas pressure of 0.19 Pa with a resonant frequency of 54.24 MHz. the second curve, B, is for a gas pressure of 0.27 Pa with a resonant frequency of 67.80 MHz. the third curve, C, is for a gas pressure 0.48 Pa with a resonant frequency of 81.36 MHz.

In each case the curves show the presence of a standing wave between the electrodes 1,2 which implies resonance of the system with the harmonic becoming the resonant. The increased RF current between the electrodes 1,2 also implies that the phenomenon identified is resonance. Since, conventionally, only a small voltage gradient is usually present within a plasma reference herein to a plasma between the electrodes and to an AC gradient within the plasma is used as reference to the ionised state of the gas and to a plasma-sheath resonance in the region between the electrodes. In any event, at the pressures involved any plasma established between the electrodes would not be in thermal equilibrium.

It will of course be apparent that the pressures given above are pressures which are not normally associated with plasma generation. Indeed, to date plasmas have only be generated at lower pressures by means of strong external magnetic fields or other forms of external ionisation sources being applied. With the plasma reactor of Figure 2 no additional external ionisation source is needed.

Although the plasma reactor described above utilises a power supply which superposes two RF frequencies, this is not essential. The results appearing in Figure 3 were obtained with a plasma reactor having a single RF power supply at a frequency of 13.56 MHz. The strength of the resonance can however be increased by pumping the reactor by means of the variable frequency power generator 11 tuned to the resonant frequency which may be a harmonic of the driving frequency. The power generator 11 may also allow the size of the voltage to be varied.

A further alternative is for the electrodes 1,2 of the reactor to be driven solely at the higher resonance frequency in which case feed-back control may be implemented to compensate for resonance effects. At a fixed electrode spacing it will be understood that variation of either the pressure of the gas in the chamber or the frequency of the power source whilst maintaining the other variable fixed enables the reactor to be tuned to resonance.

Higher gas pressures than those described above may be used with the plasma reactor of Figure 2 at lower electrode distances. For example, Using a gas such as argon, resonance can be generated up to pressures of 5 Pa for a 2 cm electrode separation.

It is proposed that the mechanism which results in the generation of a AC voltage gradient in the plasma is a result of a resonance between the plasma and the sheaths. To assist in an understanding of one theory of the mechanism Figure 4 shows a schematization of the electrical properties of the plasma reactor. This schematization is not intended to represent the true system and instead is included solely to assist comprehension. The impedance of the plasma can be represented by a combination a resistance, inductance and capacitance. At low pressures and RF frequencies the resistance is considered to be negligible. Hence, the impedance of the plasma can be treated as a parallel circuit with inductance and capacitance. The sheaths which are generated between the plasma and each electrode also have capacitance and are represented in Figure 4 by capacitors $C_1$ and $C_2$. This schematization does not of course allow for the damping effects which will be present in any real system.

The parallel LC circuit representing the plasma gives a plasma resonance which is already known to occur at very high frequencies. At frequencies below the plasma resonance frequency the plasma may be considered to be mainly inductive and can resonate in series with the capacitance of the sheaths. This series resonance produces a maximum in current transmission between the electrodes which is what is found to occur with the plasma reactor of Figure 2.

In the schematisation of Fig 4, the frequency $\omega$ of the series resonance of the plasma is dependent on the plasma resonance frequency $\omega_{pe}$, the thickness of the plasma P and the sum of the thicknesses of the sheaths S in the following relationship:

$$\omega = \frac{\omega_{pe}}{\sqrt{1 + P/S}}$$

In practice non uniformity of the plasma will modify the expression. Until the above has been shown to be true, reference herein to the resonance in the glow discharge plasma in the plasma reactor is to be understood to be reference to the increase in RF current between the electrodes which occurs at particular driving frequencies and gas pressures and to the generation of a voltage gradient between the electrodes in the form of standing waves.

With the plasma reactor of Figure 2 and the method of operation described herein, greater power can be coupled in the system than with conventional reactors and at lower pressures than have been formerly used. This enables an increase in the rate of etching or deposition without loss of quality where the reactor is used for the treatment of wafers.

Alternative arrangements of the electrodes, probe, current meter and voltage supply for example are envisaged and are considered a matter of design without departing from the spirit and scope of the present invention.

## Claims

1. A method of generating a plasma in an evacuable chamber containing a first electrode spaced apart by a separation from a second electrode, the method comprising the steps of: supplying a gas at a pressure into the chamber; connecting a first RF power source between the first and second electrodes so as to generate a glow discharge plasma with a sheath; and controlling at least one of said pressure, said first RF power source and said electrode separation so as to generate one or more voltage gradients in said plasma between the first and second electrodes characterised by the voltage gradients being generated without an externally applied magnetic field.

2. A method as claimed in claim 1, wherein resonance is generated in the plasma.

3. A method as claimed in any one of the preceding claims, wherein the electrode separation within the chamber is controlled with respect to said pressure and first RF power source.

4. A method as claimed in either of claims 1, 2 or 3, comprising the further step of monitoring an RF current between the first and second electrodes whilst adjusting at least one of said pressure, said first RF power source and said electrode separation.

5. A method as claimed in any one of the preceding claims, wherein the one or more voltage gradients in the plasma are in the form of a standing wave at a frequency near to the fundamental frequency or near to an harmonic of the fundamental frequency of the first RF power source and said method includes the steps of controlling at least one parameter from the group consisting of said pressure, voltage of said first RF power source, current of said first RF power source and electrode separation to maintain said harmonic.

6. A method as claimed in any one of the preceding claims, further comprising connecting a second RF power source between said first and second electrodes and superposing the second RF power source on the first RF power source.

7. A method as claimed in claim 6, comprising the further step of synchronously adjusting the frequencies of the first and second RF power sources and monitoring an RF current between the first and second electrodes.

8. A reactor comprising an evacuable chamber (8) having a port (8a) through which gas is supplied; first and second electrodes (1,2) located within the chamber and spaced apart from one another by a separation; pumping means (16) for maintaining sub-atmospheric pressure of gas supplied through the port (8a); a first RF power source (11,12) connected between said first and second electrodes (1,2) for generating a glow discharge plasma and sheath within the chamber (8); and characterised by means (10, 14, 15) for controlling at least one of said pressure, said RF power source and electrode separation in order to generate without an externally applied magnetic field a voltage gradient in the plasma between the first and second electrodes (1,2).

9. A reactor as claimed in claim 9, wherein said means for controlling includes a current monitor (15) for monitoring the current between the first and second electrodes (1,2).

10. A reactor as claimed in either of claims 9 or 10, further including a second RF power source (9,10) connected between said first and second electrodes (1,2).

11. A reactor as claimed in claim 10, wherein at least one of the frequency and voltage of said second RF power source (9,10) is variable.

## Patentansprüche

1. Verfahren zur Erzeugung eines Plasmas in einer evakuierbaren Kammer, die eine erste Elektrode enthält, die von einer zweiten Elektrode durch Abstand getrennt ist. Das Verfahren schließt folgende Schritte ein: Zuführen eines unter Druck stehenden Gases in die Kammer; Anschließen einer ersten HF-Stromquelle zwischen den ersten und zweiten Elektroden, um ein Glimmentladungsplasma mit einer Hülle zu erzeugen; und Steuern von mindestens einem des genannten Drucks, der genannten ersten HF-Stromquelle und genanntem Elektrodenabstand, um so einen oder mehrere Spannungsgradienten in genanntem Plasma zwischen den ersten und zweiten Elektroden zu erzeugen, dadurch gekennzeichnet, daß die Spannungsgradienten ohne ein extern angelegtes Magnetfeld erzeugt werden.

2. Verfahren nach Anspruch 1, worin Resonanz im Plasma erzeugt wird.

3. Verfahren nach einem der vorhergehenden Ansprüche, worin der Elektrodenabstand innerhalb der Kammer in bezug auf genannten Druck und die erste HF-Stromquelle gesteuert wird.

4. Verfahren nach einem der Ansprüche 1, 2 oder 3, das den weiteren Schritt der Überwachung eines HF-Stroms zwischen den ersten und zweiten Elektroden umfaßt, während es mindestens einen des genannten Drucks, genannte erste HF-Stromquelle und genannten Elektrodenabstand justiert.

5. Verfahren nach einem der vorhergehenden Ansprüche, worin der eine oder mehrere Spannungsgradient(en) im Plasma in der Form einer stehenden Welle mit einer Frequenz sind, die nahe der Nennfrequenz oder nahe einer Oberwelle der ersten HF-Stromquelle sind und genanntes Verfahren die Schritte des Kontrollierens mindestens eines Parameters aus der Gruppe einbezieht, die genannten Druck, die Spannung der genannten ersten HF-Stromquelle, den Strom der genannten ersten HF-Stromquelle und Elektrodenabstand einbezieht, um die genannte Oberwelle beizubehalten.

6. Verfahren nach einem der vorhergehenden Ansprüche, das weiter das Anschließen einer zweiten HF-Stromquelle zwischen genannten ersten und zweiten Elektroden umfaßt und die zweite HF-Stromquelle auf die erste HF-Stromquelle überlagert.

7. Verfahren nach Anspruch 6, das den weiteren Schritt der synchronen Justierung der Frequenzen der ersten und zweiten HF-Stromquellen und das Überwachen eines HF-Stroms zwischen den ersten und zweiten Elektroden einbezieht.

8. Ein Reaktor, der folgendes umfaßt: eine evakuierbare Kammer (8) mit einer Öffnung (8a), durch die Gas zugeführt wird; erste und zweite Elektroden (1, 2), die sich innerhalb der Kammer befinden und durch einen Abstand voneinander getrennt sind; Pumpmittel (16) zur Aufrechterhaltung eines Unterdrucks des Gases, das durch die Öffnung (8a) zugeführt wird; eine erste HF-Stromquelle (11, 12), die zwischen genannten ersten und zweiten Elektroden (1, 2) angeschlossen ist, um ein Glimmentladungsplasma und eine Hülle innerhalb der Kammer (8) zu erzeugen; und durch Mittel (10, 14, 15) zur Kontrolle von mindestens einem des genannten Drucks, genannter HF-Stromquelle und genanntem Elektrodenabstand gekennzeichnet ist, um einen Spannungsgradienten ohne ein extern angelegtes Magnetfeld im Plasma zwischen den ersten und zweiten Elektroden (1,2) zu erzeugen.

9. Ein Reaktor nach Anspruch 9, worin genanntes Mittel zur Kontrolle einen Stromüberwacher (15) zum überwachen des Stroms zwischen ersten und zweiten Elektroden (1, 2) einbezieht.

10. Ein Reaktor nach einem der Ansprüche 9 oder 10, der weiter eine zweite HF-Stromquelle (9, 10) einbezieht, die an die ersten und zweiten Elektroden (1, 2) angeschlossen ist.

11. Ein Reaktor nach Anspruch 10, worin mindestens eine der Frequenz und Spannung der genannten zweiten HF-Stromquelle (9, 10) variabel ist.

**Revendications**

1. Une méthode pour produire un plasma dans une chambre évacuable comprenant une première électrode et une deuxième électrode séparées l'une de l'autre, la méthode consistant à: introduire un gaz sous pression dans la chambre; raccorder une source d'alimentation électrique RF entre les deux électrodes afin de générer un plasma à décharge luminescente muni d'une gaine; et contrôler au moins l'un des paramètres suivants: ladite pression, ladite source d'alimentation RF et ledit espacement entre les électrodes, afin de générer un ou plusieurs gradients de voltage à l'intérieur du plasma et entre les deux électrodes, la méthode étant caractérisée par le fait que les gradients de voltage sont générés sans recours à un champ magnétique appliqué de façon externe.

2. Une méthode ainsi revendiquée à la revendication 1, dans laquelle une résonance est générée à l'intérieur du plasma.

3. Une méthode ainsi revendiquée à l'une quelconque des revendications précédentes, dans laquelle l'espacement des électrodes à l'intérieur de la chambre est établi par rapport à ladite pression et par rapport à la première source électrique RF.

4. Une méthode ainsi revendiquée à l'une quelconque des revendications 1, 2 ou 3, comprenant une étape supplémentaire, à savoir le contrôle d'un courant RF entre les deux électrodes tout en réglant au moins l'un des paramètres suivants, à savoir ladite pression, ladite première source RF et ledit espacement entre les électrodes.

**5.** Une méthode ainsi revendiquée à l'une quelconque des revendications précédentes, dans laquelle le ou les gradients de voltage à l'intérieur du plasma se présentent sous la forme d'une onde stationnaire dont la fréquence est proche de la fréquence fondamentale ou d'un harmonique de la fréquence fondamentale de la première source d'électricité RF, et dans laquelle ladite méthode permet le contrôle d'au moins l'un des paramètres suivants, à savoir ladite pression, le voltage de ladite première source RF, le courant de ladite première source RF et ledit espacement entre les électrodes, afin de maintenir ledit harmonique.

**6.** Une méthode ainsi revendiquée à l'une quelconque des revendications précédentes, comprenant en outre le raccordement d'une seconde source électrique RF entre lesdites électrodes, la seconde source électrique RF se superposant à la première source électrique RF.

**7.** Une méthode ainsi revendiquée à la revendication 6, comprenant en outre l'étape consistant à régler de façon synchrone les fréquences des première et deuxième sources électriques, et à contrôler un courant RF entre les deux électrodes.

**8.** Un réacteur comprenant une chambre évacuable (8) comportant un port d'entrée (8a) destiné à alimenter la chambre en gaz; deux électrodes (1,2) situées à l'intérieur de la chambre et séparées l'une de l'autre par un espacement; un dispositif de pompage (16) destiné à maintenir le gaz introduit depuis le port (8a) à une pression sous-atmosphérique; une première source électrique RF (11,12) raccordée entre les deux électrodes (1,2) et générant un plasma à décharge luminescente muni d'une gaine à l'intérieur de la chambre (8); et caractérisé par un dispositif (10,14,15) destiné à contrôler au moins l'un des paramètres suivants : ladite pression, ladite source électrique RF, et l'espacement entre les électrodes, afin de générer sans recourir à un champ magnétique appliqué de façon externe un gradient de voltage à l'intérieur du plasma et entre les deux électrodes (1,2).

**9.** Un réacteur ainsi revendiqué à la revendication 9, dans lequel ledit dispositif de contrôle comporte un moniteur de courant (15) destiné à contrôler le courant circulant entre les deux électrodes (1,2).

**10.** Un réacteur ainsi revendiqué à la revendication 9 ou à la revendication 10, comprenant en outre une deuxième source électrique RF (9,10) raccordée entre les deux électrodes (1,2).

**11.** Un réacteur ainsi revendiqué à la revendication 10, dans lequel on peut faire varier la fréquence et/ou le voltage de ladite seconde source électrique (9,10).

Figure 1

Figure 4

Figure 2

EP 0 719 447 B1

Figure 3